Europäisches Patentamt

European Patent Office

Office européen des brevets

(11) Publication number: **0 140 523**
**B1**

## EUROPEAN PATENT SPECIFICATION

(45) Date of publication of patent specification: **18.10.89**

(51) Int. Cl.⁴: **C 30 B 21/02**

(21) Application number: **84305834.8**

(22) Date of filing: **24.08.84**

(54) Directional solidification of Bi/MnBi compositions.

(30) Priority: **26.08.83 US 526802**

(43) Date of publication of application:
**08.05.85 Bulletin 85/19**

(45) Publication of the grant of the patent:
**18.10.89 Bulletin 89/42**

(84) Designated Contracting States:
**DE FR GB NL**

(56) References cited:
JOURNAL OF CRYSTAL GROWTH, vol. 52, part 2, April 1981, pages 519-523, Amsterdam, NL; E.M. SAVITSKY et al.: "Effect of crystallization in magnetic field on the structure and magnetic properties of Bi-Mn alloys"

JOURNAL OF APPLIED PHYSICS, vol. 38, no. 13, December 1967, pages 5211-5216; W.M. YIM et al.: "Preparation and properties of eutectic Bi-MnBi single crystals"

J.Appl.Phys.50(3), March '79, pp.2425-2427

(73) Proprietor: GRUMMAN AEROSPACE CORPORATION
South Oyster Bay Road
Bethpage, NY 11714 (US)

(72) Inventor: Pirich, Ronald G.
167 Newbrook Lane
Bay Shore New York 11706 (US)
Inventor: Larson, David J.
15 Tasman Lane
Huntington Station New York 11746 (US)

(74) Representative: Lewin, John Harvey et al
ELKINGTON AND FIFE Beacon House 113 Kingsway
London WC2B 6PP (GB)

Courier Press, Leamington Spa, England.

# Description

This invention relates to the improved permanent magnet properties of MnBi rods, in the equilibrium phase (LTP) grown by directional solidification. Moreover, this invention relates to MnBi rods which contain a high coercivity or HC phase which provides exceptionally high permanent magnet properties at cryogenic temperature and can serve as a magnetic switch. The aforesaid high coercivity or HC phase is found to coexist with the LTP phase.

The novelly produced Bi/MnBi rods of this invention serve as permanent magnet material for temperatures in the range of −50°C to +150°C and at cryogenic temperature. These permanent magnet properties are comparable to presently used sintered rare earth-cobalt permanent magnets and can be mass produced at reduced costs.

The permanent magnet (ferromagnetic) character of MnBi has long been established by a number of investigators. The MnBi intermetallic, which has a hexagonal NiAs crystal structure, possesses one of the highest magnetocrystalline anisotropies $(K_1=0.91 \text{ J/cm}^3, K_2=0.26 \text{ J/cm}^3)$ and magnetostrictions $(\lambda_1=-800\times10^{-6})$ of any material other than the rare earth-cobalt alloys.

In order to optimize the permanent magnet figures of merit for this system, i.e. remanent induction, intrinsic coercivity and energy product: (1) the magnetic moment of each magnetic region or domain should be aligned with every other region such that each moment lies along the easy axis of magnetization and (2) the average domain size should be reduced below a critical size at which a single-domain structure is of lower energy (and hence more probable to exist) than a multi-domain structure and below which magnetization reversal by coherent rotation is favoured over domain wall motion, reversed domain nucleation or incoherent curling processes.

However, the permanent magnet figures of merit may also be a sensitive function of the shape of the magnetic domain (shape anisotropic), the elastic deformation of a domain under application of an external magnetic field (magnetostriction), local demagnetizing fields at surface irregularities or inclusions of the domains (strain), local elastic strains near dislocations and other lattice defects (magnetostriction, anti-ferromagnetic coupling, domain wall pinning), a local Bi-rich region produced by preferential oxidation of Mn (local reduction in magnetocrystalline anisotropy) or the coexistence of a second magnetic phase which could be ferromagnetic (magnetic coupling) or paramagnetic (ultra fine MnBi particles).

Previous attempts to produce permanent magnets using MnBi have involved hot-pressing of powder in a very high external magnetic field which presumably aligns the easy axis of magnetization of different particles. The coercive field for MnBi powder was found to be extremely sensitive to average particle size, varying from intrinsic coercivity $_mH_c$ of 600 Oe for 100 μm diameter particles to 12000 Oe for particles less than 3 μm in size. Unfortunately, due to the shape and deformation of the powder crystallites, permanent magnet properties achieved with MnBi powder are:

remanent induction (Br)=4300 gauss.
intrinsic coercivity $(_mH_c)$=3400 Oe.
maximum static energy product $(BH)_{max}$=4.3 MG-Oe at room temperature as compared with the theoretical maximum of:
Br=8200 gauss.
$_mH_c$=35000 Oe.
$(BH)_{max}$=17 MG-Oe.

We have used a different approach involving plane-front directional solidification to achieve particles of MnBi whose size is an order of magnitude less (<0.5 μm) than those obtained previously by grinding and crushing.

Journal of Applied Physics, volume 38, No. 13, December 1967, pages 5211—5216 describes a method for the directional solidification of Bi/MnBi compositions to produce magnetic single domain size MnBi particles in aligned array by directionally solidifying a composition containing Mn and Bi, said composition containing 0.72% by weight Mn, at a solidifying rate of about 0.6 cm/h and at a thermal gradient of about 40°C/cm. The MnBi needles have a diameter of about 4 μm.

Journal of Applied Physics, volume 50, No. 3, March 1979, pages 2425 to 2427 describes a method for the directional solidification of Bi/MnBi compositions to produce magnetic single domain size MnBi particles, in aligned array, having a particle size of about 0.5 μm, by directionally solidifying a composition containing Mn and Bi, said composition containing 97.8 atomic percent Bi, and post-heating the formed MnBi composite at a temperature of 200°C.

The present invention provides a method for the directional solidification of Bi/MnBi compositions to produce magnetic single domain size MnBi particles, in aligned array, having a particle size of less than 1 μm and an Mn concentration of up to 50 atomic percent, comprising directionally solidifying a composition containing Mn and Bi, said composition containing from 0.1% to 50% by atomic fraction Mn, at a solidifying rate of from 0.5 cm/h to 50 cm/h and at a thermal gradient, in the liquid at the liquid-solid interface, of from 10°C/cm to 1,000°C/cm wherein an MnBi composite is formed; and hot rolling or extruding, during post-heat treatment, at a temperature in the range of from 200°C to 260°C for a period of from 1 to 100 hours under an inert atmosphere.

In one embodiment of the above process, a magnetic single domain size MnBi particle composite is obtained which contains about 0.72% by weight Mn (eutectic) which employs a solidifying rate of 30 cm/h at a thermal gradient of 100°C/cm.

In another embodiment of the above process, a magnetic single domain size MnBi particle composite is obtained which contains from 0.72 to 20.8% by weight Mn (Mn rich off-eutectic) which employs a solidifying rate of 0.5 cm/h to 50 cm/h and a thermal gradient of from 100 to 1000°C/cm.

The inventive method disclosed herein involves the directional solidification at various growth velocities (0.5 cm/h to 50 cm/h) and improved thermal gradients (10°C/cm to 1000°C/cm) of eutectic and off-eutectic Bi/MnBi resulting in MnBi rods characterised by near theoretical permanent magnet properties after post-heat treatment.

Sample preparation and processing

Samples were prepared using high purity Mn (99.9) and Bi (99.999) which were melted together in an evacuated quartz crucible above 446°C, the temperature at which the stoichiometric MnBi compound forms. The starting proportions were Mn-rich. Portions of these starting boules were then remelted in a specially designed evacuated quartz crucible and directionally solidified at various growth velocities and thermal gradients using the Bridgman-Stockbarger technique. Controlled directional solidification of MnBi produces an aligned array of chevron-type cross-section shaped MnBi rods whose average effective rod diameter follows a (growth velocity)$^{-1/2}$ law in thermal gradients varying from 10°C/cm to 1000°C/cm.

Magnetic properties

Magnetization, measured parallel to the growth direction for MnBi and parallel as well as perpendicular for Bi, as a function of applied field (−230 to 230 kG) at temperatures of 4.2, 77, 295 and 538 K was used to characterize the magnetic properties.

At room temperature, there is ample experimental evidence for the existence of two ferromagnetic MnBi phases. One phase, the low-temperature (LTP) or equilibrium MnBi phase has an anisotropy energy which is a monotonically decreasing function below 500 K with an expected intrinsic coercivity of 30 kOe for Stoner-Wohlfarth single domain, coherent rotation particles at room temperature. The other so-called quenched-high-temperature-phase (QHTP), which is stable above 613 K, can be represented as $Mn_{1.08}Bi$ where it is assumed that 15% of the Mn atoms of the MnBi compound occupy octahedral, interstitial positions in its NiAs structure. Recently, we have observed the existence of a third magnetic phase and termed it the High Coercive Strength or HC phase.

We find that the HC phase is paramagnetic at room temperature and orders ferromagnetically between 295 K and 77 K with an intrinsic coercivity of 120 kOe at 77 K, and with a remanent induction of about 2800 gauss. The magnitude of the intrinsic coercivity and shape of the demagnetization curve for the HC phase at 77 K is suggestive of Stoner-Wohlfarth single domain, coherent rotation particles. The amount of HC phase is a function of growth velocity and thermal gradient. We find more of the HC phase and correspondingly less of the LTP for larger growth velocities and thermal gradients.

The room temperature intrinsic coercivity for samples processed only by directional solidification (which we call the as-grown state) appears to be a weakly dependent function of the average dispersed MnBi particle size except for very high growth velocities where the samples become almost paramagnetic in character, i.e., where at least 50% of the MnBi particles consist of the HC phase. We have seen dramatic improvement at room temperature not only in saturation magnetization and remanent induction but also in intrinsic coercivity and energy product after a 24 hour heat-treatment anneal, since the HC phase undergoes conversion to the LTP phase as a function of the heat treatment anneal.

Our results suggest that the coexistence of the HC phase with the LTP phase limits the room temperature intrinsic coercivity of the LTP phase for effective MnBi particle diameters $<D>\geq2.0$ μm and enhance it for $<D>\geq3.5$ μm. This behaviour is similar to that observed in certain rare earth-cobalt materials in which the introduction of a region of reduced magnetocrystalline anisotropy (magnetic defect) can either enhance (pinning) or decrease (nucleation of reverse domains) the intrinsic coercivity. We have achieved permanent magnet properties for those MnBi rods containing the LTP phase which are >98% the theoretical maximum. Over the temperature range from −50°C to +150°C, these permanent magnet figures of merit are competitive with those of the rare earth-cobalt family currently produced by a sintering process.

In addition, we are able to produce the HC phase, though unstable at elevated temperatures, which is stable below 100 K with magnetic properties which makes it a superior permanent magnet material for use in cryogenic environments.

We produce rods of

$$(LTP)_{1-x}(HC)_x (0\leq x\leq 1)$$

MnBi rods by directional solidification, varying the amount (volume fraction) of MnBi if hot-rolling or extruding the ds product and form various forms or shapes whose permanent magnet figures of merit can be optimized for use at room and elevated temperatures (−50°C to +150°C) for motor applications (for example) or for use at cryogenic temperatures (<100 K) cr as a magnetic switch (paramagnetic at T>290 K and ferrimagnetic for T<100 K). This choice of magnetic properties can be achieved by a suitable heat-treatment anneal of the as-grown MnBi rods (i.e. a suitable x in $(LTP)_{1-x}(HC)_x$).

Also, since the cost in materials (50% Mn+50% Bi) in making 1 gram of MnBi is at least one order of magnitude lower than the cost in materials (33% Sm+67% Co) of making 1 gram of $SmCo_5$ and in view of the opinion that the overriding cost in mass production is ultimately materials cost limited, the alternative of LTP MnBi rod magnet is of equivalent (to sintered $SmCo_5$ or (misch-metal) $Co_5$) permanent magnet performance is attractive.

The choice of a binder material can be a polymer material for HC rod, permanent magnets at cryogenic temperatures, LTP rod permanent magnets −50°C to +150°C) and for the magnetic switch (LTP)$_{1-x}$(HC)$_x$ (for intermediate 0<x<1) or a compaction of LTP rods for room to elevated temperature regimes.

Example

Employing a Bridgman-Stockbarger type directional solidification apparatus whose hot zone is maintained at 460°C, whose cold zone is maintained at 25°C, thus giving rise to a thermal gradient in the liquid melt at the solid-liquid interface of about 100°C/cm. The melt is directionally solidified at a growth velocity (furnace speed) of about 30 cm/h. Hot rolling or extruding during post-heat treatment is carried out as described above.

Morphology and magnetic properties

The above solidification conditions for the eutectic composition (.72% Mn) results in a compositionally uniform product whose morphology is characterised by an aligned ensemble of MnBi rods whose long axis lies along the solidification direction (direction of heat flow) with an average MnBi rod diameter of 0.5 μm.

The magnetic properties in the as grown state (no post-solidification heat treatment) are characterised by a non-equilibrium magnetic phase (high coercivity or HC). This phase is paramagnetic at room temperature and orders ferrimagnetically at 240°K in the order state, i.e., below 240°K, the saturation magnetization is 220 emu/cm$^3$ and the resistance to demagnetization or intrinsic coercivity is 120 kOe.

For those samples which are heat treated between 200 and 260° for periods of between 1 and 100 hours the non-equilibrium HC phase transforms to the equilibrium ferromagnetic LTP Mn-Bi phase or a fully transformed sample, the saturisation magnetization is 660 emu/cm$^3$ and the intrinsic coercivity is 35 kOe at room temperature.

These values are the theoretically predicted maximum for equilibrium MnBi.

**Claims**

1. A method for the directional solidification of Bi/MnBi compositions to produce magnetic single domain size MnBi particles, in aligned array, having a particle size of less than 1 μm and an Mn concentration of up to 50 atomic percent, comprising directionally solidifying a composition containing Mn and Bi, said composition containing from 0.1% to 50% by atomic fraction Mn, at a solidifying rate of from 0.5 cm/h to 50 cm/h and at a thermal gradient, in the liquid at the liquid-solid interface, of from 10°C/cm to 1,000°C/cm wherein an MnBi composite is formed; and hot rolling or extruding, during post-heat treatment, at a temperature in the range of from 200°C to 260°C for a period of from 1 to 100 hours under an inert atmosphere.

2. The method of claim 1 for the production of a magnetic single domain size MnBi particle composite which contains 0.72 by weight Mn (eutectic), wherein said solidifying rate is 30 cm/h and said thermal gradient is 100°C/cm.

3. The method of claim 1 for the production of a magnetic single domain size MnBi particle composite which contains from 0.72 to 20.8% by weight Mn (Mn rich off eutectic), wherein said solidifying rate is 0.5 cm/h to 50 cm/h and said thermal gradient is from 100°C/cm to 1000°C/cm.

4. The method of claim 1 for the production of a magnetic single domain size MnBi particle composite which contains from 0.11 to 0.72% by weight Mn (Bi rich off eutectic), wherein said solidifying rate is 0.5 cm/h to 50 cm/h and said thermal gradient is from 10°C/cm to 200°C/cm.

5. The method of claim 1 wherein said post-heat treatment is effected in a vacuum furnace at a temperature of from 200 to 260°C for a period of 1 to 100 hours and at a pressure of less than 1.33×10$^{-3}$ Pa or in an inert atmosphere.

6. The method of claim 1 wherein said post-heating step is conducted under an atmosphere of argon gas.

**Patentansprüche**

1. Verfahren zur gerichteten Erstarrung von Bi/MnBi-Zusammensetzungen zur Herstellung magnetischer Einbereichsgrößen-MnBi-Partikel in axial ausgerichteter Anordnung mit einer Partikelgröße von weniger als 1 μm und einer Mn-Konzentration bis zu 50 Atom-%, wobei das Verfahren enthält:

—gerichtete Erstarrung einer Zusammensetzung, die Mn und Bi enthält, wobei die Zusammensetzung von 0,1% bis 50% an der Atomfraktion Mn enthält, bei einer Erstarrungsrate von 0,5 cm/h bis 50 cm/h und einem thermischen Gradienten in der Flüssigkeit an der flüssig-festen Grenzfläche von 10°C/cm bis 1000°C/cm, worin ein MnBi-Verbundwerkstoff gebildet wird; und

—Warmbarrenwalzen oder Strangpressen während nachträglicher Wärmebehandlung bei einer Temperatur in dem Bereich von 200°C bis 260°C für eine Zeit von 1 bis 100 Std. unter einer inerten Atmosphäre.

2. Verfahren gemäß Anspruch 1, zur Herstellung eines magnetischen Einbereichsgrößen-MnBi-Partikel-Verbundwerkstoffs, der 0,72 Gew.-% Mn (eutektisch) enthält, bei dem die Erstarrungsrate 30 cm/h und der thermische Gradient 100°C/cm beträgt.

3. Verfahren gemäß Anspruch 1 zur Herstellung eines magnetischen Einbereichsgrößen-MnBi-Partikel-Verbundwerkstoffs, der von 0,72 bis 20,8 Gew.-% Mn (Mn reich an Eutektikum), bei dem die Erstarrungsrate 0,5 cm/h bis 50 cm/h und der thermische Gradient von 100°C/cm bis 1000°C/cm beträgt.

4. Verfahren gemäß Anspruch 1 zur Herstellung eines magnetischen Einbereichsgrößen-MnBi-Partikel-Verbundwerkstoffs, der von 0,11 bis 0,72 Gew.-% Mn (Bi reich an Eutektikum) enthält, bei dem die Erstarrungsrate 0,5 cm/h bis 50 cm/h und der thermische Gradient von 10°C/cm bis 200°C/cm beträgt.

5. Verfahren gemäß Anspruch 1, bei dem die nachträgliche Wärmebehandlung in einem Vakuumgefäß bei einer Temperatur von 200 bis 260°C für eine Zeit von 1 bis 100 Std. und bei einem Druck von weniger als $1{,}33\times10^{-3}$ Pa oder in einer inerten Atmosphäre bewirkt wird.

6. Verfahren gemäß Anspruch 1, bei dem der nachträgliche Erwärmungsschritt unter einer Argongasatmosphäre durchgeführt wird.

**Revendications**

1. Procédé pour la solidication directionnelle de compositions Bi-MnBi en vue de l'obtention de particules de MnBi magnétique de grosseur monodomaine, en formation alignée, ayant une grosseur de particule de moins de 1 μm et une concentration en Mn allant jusqu'à 50% en pourcentage atomique, caractérisé en ce qu'il comprend la solidification directionnelle d'une composition contenant de 0,1% à 50% en fraction atomique de Mn, à une vitesse de solidification de 0,5 à 50 cm/h et avec un gradient thermique, dans le liquide situé à l'interface liquide/solide, de 10 à 1 000°C/cm, lors de laquelle il se forme un composé MnBi et un laminage à chaud ou une extrusion opérés, au cours du traitement de post-chauffage, à une température comprise entre 200 et 260°C pendant un temps de 1 à 100 heures sous atmosphère inerte.

2. Procédé selon la revendication 1 pour la fabrication d'un composé magnétique à particules de MnBi de grosseur monodomaine contenant 0,72% en poids de Mn (eutectique), caractérisé en ce que ladite vitesse de solidification est de 30 cm/h et ledit gradient thermique est de 100°C/cm.

3. Procédé selon la revendication 1 pour la fabrication d'un composé magnétique à particules de MnBi de grosseur monodomaine contenant 0,72 à 20,8% en poids de Mn (non eutectique riche en Mn), caractérisé en ce que ladite vitesse de solidification est de 0,5 à 50 cm/h et ledit gradient thermique est de 100 à 1000°C/cm.

4. Procédé selon la revendication 1 pour la fabrication d'un composé magnétique à particules de MnBi de grosseur monodomaine contenant 0,11 à 0,72% en poids de Mn (non eutectique riche en Bi), caractérisé en ce que ladite vitesse de solidification est de 0,5 à 50 cm/h et ledit gradient thermique est de 10 à 200°C/cm.

5. Procédé selon la revendication 1, caractérisé en ce que ledit traitement de post-chauffage est effectué dans un four à vide à une température de 200 à 260°C pendant un temps de 1 à 100 heures et sous une pression de moins de $1{,}33\times10^{-3}$ Pa ou sous atmosphère inerte.

6. Procédé selon la revendication 1, caractérisé en ce que ladite opération de post-chauffage est effectuée sous atmosphère de gaz argon.